# EUROPEAN PATENT SPECIFICATION

(11) **EP 4 576 314 B1**
(45) Date of publication and mention of the grant of the patent: **09.12.2026**
(21) Application number: 23219425.8
(22) Date of filing: 21.12.2023
(51) Int. Cl.: H01M 10/42, H01M 50/519, H01M 50/569, H02J 7/62, H02J 7/65, H02J 7/80, G01R 31/36, G01R 31/364, H01M 10/48, H01M 50/581, H01M 50/583, G01R 1/20, G01R 31/382, H02J 7/00

(54) **BATTERY CONTROL UNIT AND HIGH VOLTAGE POWER SUPPLY SYSTEM**
BATTERIESTEUEREINHEIT UND HOCHSPANNUNGSSTROMVERSORGUNGSSYSTEM
UNITÉ DE COMMANDE DE BATTERIE ET SYSTÈME D'ALIMENTATION ÉLECTRIQUE HAUTE TENSION

(43) Date of publication of application: 25.06.2025
(73) Proprietor: Munich Electrification GmbH, 81373 Munich (DE)
(72) Inventor: Goede, Stefan, 81373 Munich (DE); Tóth, Bálint, 81373 Munich (DE); Zhu, Iván Liu, 81373 Munich (DE)
(74) Representative: Grünecker Patent- und Rechtsanwälte PartG mbB

(56) References cited:
- EP-A1- 3 651 237
- US-A1- 2022 200 214

## Description

The present disclosure relates to a battery control unit and a high voltage power supply system comprising the battery control unit.

With the advanced development of electric vehicles (EV), in particular battery electric vehicles (BEV), and hybrid electric vehicles (HEV), in particular plug-in hybrid electric vehicles (PHEV), high voltage (HV) batteries become more and more common in vehicles like buses, trucks or passenger cars. Typically, high voltage batteries used in electric vehicles are formed of one or more battery packs and comprise 80 to 300 battery cells ("cells") connected in series and/or in parallel, to be capable of supplying high voltages in a range between 400 V and 1000 V. In future applications, even more battery cells may be used and higher voltages may be supplied by the high voltage batteries.

High voltage batteries require a battery management system (BMS) in order to detect cell voltages, perform cell balancing, and monitor the cell temperature for improving the available capacity of the battery pack and increase the individual longevity of each cell. Based on the detected values, the BMS connects and disconnects the battery pack to and from a DC bus that connects the HV battery to external loads (or to a charger) by controlling the operation of contactors, which are electrically connected in series with the positive and negative terminals of the HV battery. Examples of the external loads include high voltage components, like motor inverters (DCAC converters), DCDC converters, or chargers (ACDC converters), heaters, auxiliary loads or other high voltage components. For ensuring proper operation of the contactor device, the BMS monitors the voltages dropping across each of the contactors. For this purpose, the BMS is usually connected by cable connections to voltage measuring contact pairs, which allow for detecting the respective voltages.

Furthermore, in order to prevent overcurrent, which may harm the HV battery or the electric components electrically connected to the HV battery, the BMS needs to monitor a battery current provided by the battery. For this purpose, the BMS usually is connected by cable connections to at least one current sensor, which is electrically connected in series with the HV battery, and is often provided in form of a dedicated shunt resistor. In case an overcurrent is detected by the BMS, the overcurrent should be interruptible immediately and permanently. For this purpose, it is known to connect an additional overcurrent protection device, like a circuit breaker, a fuse or a pyro-fuse in series to the HV battery. Hereby, the activation and functioning of the overcurrent protection device is also controlled by the BMS.

For example, EP 3 651 237 A1 discloses a battery pack, which includes a BMS assembly having a BMS circuit board, a current sensor unit vertically fixed to an edge of the BMS circuit board, and a BMS housing supporting the BMS circuit board.

US 2022/200214 A1 discloses a multifunction carrier for receiving circuit components of a battery system for an electric vehicle. The multifunction carrier includes a busbar assembly with at least one charging connection rail and a drive connection rail, and an insulating housing, in which the busbar assembly is embedded.

In this respect, the inventors of the present invention have recognized that there is still room for improvement in connecting the detection contacts of the battery management system to the detection contacts of the HV battery power supply system. Accordingly, it is an object of the present invention to provide an improved battery control unit, and a power supply system, which can provide a higher level of functional integration and/or can lower the necessary interconnection efforts between the dedicated electric components. Furthermore, it is an object of the present invention to provide a space-saving and economic solution.

At least one of these objects is solved by the subject matter of the independent claims. Advantageous aspects of the present disclosure are the subject matter of the dependent claims.

According to a first aspect, the present disclosure provides a battery control unit, which comprises a switch device, and an assembled circuit, which is mounted on a circuit board. The assembled circuit includes detection circuitry, which is configured to detect at least one operational parameter of the switch device, processing circuitry, which is configured to control the operation of the switch device in accordance with the at least one operational parameter detected by the detection circuitry, and a plurality of detection contacts for detecting the at least one operational parameter of the switch device. The battery control unit further comprises a bus bar arrangement, which comprises an input bus bar, which is conductively coupled to an input terminal of the switch device, and an output bus bar, which is conductively coupled to an output terminal of the switch device, wherein the circuit board is disposed with respect to the bus bar arrangement such that the plurality of detection contacts abut against corresponding contact surfaces being provided on the input bus bar and on the output bus bar.

In other words, the present disclosure is based on the idea of abolishing the need for providing cable connections between a battery control unit of a battery management system, which sometimes is signified as a (smart) battery sensor, and the detection contacts of a power supply system, by integrating a part of the bus bars of the power supply system into a battery control unit, and by providing detection contacts for the control circuitry of the BMS, which can be pressed onto the bus bars of the battery control unit to make contact. Accordingly, the present disclosure allows for substantially reducing the interconnection efforts between the control circuits (detection and processing circuits) of the BMS and the bus bars (or leads) of the power supply system, and also allows for providing a device, which reduces the required installation space.

According to a second aspect, the input bus bar and the output bus bar each comprise a main body portion, which extends substantially parallel to the circuit board, wherein an end region of the input bus bar, which is conductively coupled with the input terminal of the switch device is bent with respect to the main body portion of the input bus bar, and wherein an end region of the output bus bar, which is conductively coupled with the output terminal of the switch device is bent with respect to the main body portion of the output bus bar.

By bending up the input bus bar and the output bus bar, and in particular the end regions of the input bus bar and of the output bus bar, which are connected to the terminals of the switch device, it is possible to achieve a compact design of the battery control unit, because the switch device can be installed above the main body portions of the bus bars and above the circuit board, i.e. on a same base area, which is spanned by the main body portions of the bus bars. For maximizing the space saving, for example, a bending angle between the main body portion and the end region of the input bus bar and of the output bus bar lies preferably between 70° and 110°, more preferably between 80° and 100°, and most preferably is approximately 90°.

In order to further reduce the required installation space for the battery control unit, according to a third aspect, the circuit board is disposed between the switch device and a plane, which is spanned by the main body portions of the input bus bar and of the output bus bar. In other words, the bus bars of the bus bar arrangement, the circuit board, which carries the assembled circuit and the switch device are advantageously stacked above each other in a direction from the bottom to the top of the battery control unit, so that a base area of the battery control unit can be reduced. According to a fourth aspect, the battery control unit further comprises a bus bar housing element, which houses the input bar and the output bus bar, wherein the bus bar housing element isolates the input bus bar and the output bus bar from the assembled circuit and exposes the contact surfaces of the input bus bar and of the output bus bar to the plurality of detection contacts.

In this manner, the bus bar housing element carries the main body portions of the input bus bar and of the output bus bar in a constant distance to the circuit board of the assembled circuit, while the bus bar housing element holds and isolates the bus bars of the bus bar arrangement from the assembled circuit. Furthermore, the bus bar housing element can also provide a support surface for the circuit board and stabilize the circuit board against impacts, like vibrations and shocks, from the outside. For providing a highly reproducible, simple and cost-efficient manufacturing process, the bus bars of the bus bar arrangement are overmolded with a thermosetting polymer to form the bus bar housing element. Alternatively, for example, an injection molding process can be applied for fabricating the bus bar housing element.

According to a fifth aspect, a bottom surface of the bus bar housing element, which faces away from the assembled circuit, is covered with an insulating bottom cover, which is formed of an insulating heat conducting material, and an external surface of the insulating bottom cover forms a cooling surface for cooling the input bus bar and the output bus bar. In this manner, an efficient thermal management of the battery control unit can be achieved and the heat generated in the bus bars is directed towards the cooling surface, instead of heating up the electronic components of the assembled circuit.

According to a sixth aspect, the plurality of detection contacts are formed of compressible contact elements, wherein the plurality of detection contacts in particular are each formed of a strap-shaped metal band, which is filled with an insulating foam. By using the elasticity of the compressible contact elements, it is possible to provide a reliable contact mechanism between the assembled circuit and the bus bar arrangement. In particular, the elasticity of the compressible contacts also allows for compensating manufacturing tolerances, while at the same time a reliable contacting is guaranteed.

According to a seventh aspect, the corresponding contact surfaces of the input bus bar and of the output bus bar are integrally formed with the top surfaces of the input bus bar and of the output bus bar, which face towards the assembled circuit. This aspect advantageously contributes in providing a compact design of the battery control unit. In an alternative implementation, it is however possible that the bus bars of the bus bar arrangement comprise projecting holding arms, which each may carry a contact surfaces contacting the corresponding detection contact of the assembled circuit.

According to an eighth aspect, a first one of the plurality of detection contacts abuts against a corresponding contact surfaces being provided on the input bus bar and a second one of the plurality of detection contacts abuts against a corresponding contact surface being provided on the output bus bar. Further, the detection circuitry comprises a first detection circuit, which is configured to detect a voltage dropping between the first one of the plurality of detection contacts and the second one of the plurality of detection contacts, and the processing circuitry is configured to determine a voltage value of the voltage dropping across the switch device as an operational parameter of the switch device.

In this manner, the processing circuitry of the battery control unit can directly determine the voltage dropping across the switch device, without the need of contacting the detection points of the bus bars by cable, and, by using integrated internal control functions, control opening and closing of the switch device based on the determined voltage drop for ensuring safe operation of the switch device.

According to a ninth aspect, the bus bar arrangement comprises at least one resistor element having a predefined resistance. A third one of the plurality of detection contacts and a fourth one of the plurality of detection contacts abut against corresponding contact surfaces of the bus bar arrangement, which are arranged for detecting a resistor voltage dropping across the resistor element, the detection circuitry comprises a second detection circuit, which is configured to detect the resistor voltage dropping across the resistor element between the third one of the plurality of detection contacts and the fourth one of the plurality of detection contacts, and the processing circuitry is configured to determine a current value of a current flowing through the switch device as the at least one operational parameter based on the detected resistor voltage.

In this manner, the battery control unit detection can directly determine the current flowing through the switch device, which corresponds to a battery current of a battery electrically connected with the battery control unit, without the need of contacting the detection points of a dedicated shunt resistor by a cable. Further, by using integrated internal control functions, the battery control unit can control opening and closing of the switch device based on the determined current value for ensuring safe operation of the battery and of the switch device.

In an optional implementation of the ninth aspect, the resistor element is integrally formed with one of the input bus bar and of the output bus bar. In this manner, the need for providing a dedicated shunt resistor can be dispensed, so that the number of necessary interconnections in the battery control unit can be reduced and the energy loss and unintended heat generation decreases.

According to a tenth aspect, the assembled circuit comprises a temperature sensor, which is thermally coupled with at least one of the input bus bar and of the output bus bar by at least one of the plurality of detection contacts, and the processing circuitry is configured to determine a temperature of the temperature sensor as an operational parameter of the switch device.

In this manner, the battery control unit detection can directly determine the temperature of at least one of the bus bars without the need of contacting the detection points of the bus bar by a cable. Further, by using integrated internal control functions, the battery control unit can control opening and closing of the switch device based on the determined temperature for ensuring safe operation for ensuring safe operation of the battery and of the switch device.

According to an eleventh aspect, the bus bar arrangement further comprises a ground terminal, which is electrically isolated from the input bus bar and from the output bus bar, for electrically connecting a ground potential. A fifth one of the plurality of detection contacts abuts against a corresponding contact surface of the ground terminal, the detection circuitry comprises a third detection circuit, which is configured to detect a third detection voltage, which is indicative of a leakage path resistance between the ground terminal and one of the input bus bar and of the output bus bar, and the processing circuitry is configured to determine the leakage path resistance as an operational parameter of the switch device.

By making electrical contact between the circuitry of the assembled circuit and the ground terminal, the electromagnetic compatibility (EMC) of the assembled circuit is enhanced. Further, the battery control unit detection can directly determine a leakage path resistance between one or more of the bus bars of the bus bar arrangement and the ground terminal, which is for example connected to a chassis of a vehicle to define the ground potential of the battery control unit, without the need of contacting the ground terminal by a cable. Further, by using integrated internal control functions, the battery control unit can control opening and closing of the switch device based on the determined leakage path resistance for ensuring safe operation of the battery and of the switch device.

According to a twelfth aspect, the assembled circuit comprises a first communication interface for performing communication with at least one cell monitoring device, which monitors battery parameters of a high voltage battery, and the processing circuitry is configured to control the operation of the switch device in accordance with at least one of the battery parameters, which is received by the first communication interface from the cell monitoring device. Alternatively or in addition, the assembled circuit comprises a second communication interface for performing communication with an external controller, which is configured to control a high voltage battery, and the processing circuitry is configured to control the operation of the switch device in accordance with a control command, which is received by the second communication interface from the external controller.

In this manner, the battery control unit detection can receive battery parameters, like cell voltages and cell temperatures from the cell monitoring device and/or control commands from an external controller, like an electronic control unit (ECU) of a vehicle and can control opening and closing of the switch device based on the received battery parameters and/or based on the received control commands.

In order to enhance the integration of control functions into the battery control unit, according to a thirteenth aspect, the switch device is configured to switch between an open state and a closed state, wherein in the open state current flow through the switch device is interrupted, and in the closed state current flow through the switch device is allowed, and the processing circuitry is configured to switch the switch device in accordance with the at least one operational parameter detected by the detection circuitry. Alternatively or in addition the battery control unit further comprises at least one overcurrent protection device, which is configured to prevent overcurrent to flow through the switch device, and the processing circuitry is configured to control the operation of the at least one overcurrent protection device in accordance with the at least one operational parameter detected by the detection circuitry. The overcurrent protection device, can for example be a circuit breaker, a fuse or a pyrofuse. But also other suitable devices, which allow for immediately breaking an excessive overcurrent in a high voltage power supply system are suitable. In an optional implementation of the thirteenth aspect, the overcurrent protection device is integrated into the switch device to form an integral part of the switching device.

According to a fourteenth aspect, there is also provided a power supply system, which comprises at least one battery and the battery control unit according to one of the first to thirteenth aspects, wherein the at least one battery is conductively coupled to the switch device.

According to a fifteenth aspect, there is also provided a method for assembling a battery control unit. The method comprises the step of mounting an assembled circuit on a circuit board, wherein the assembled circuit includes detection circuitry, which is configured to detect at least one operational parameter of a switch device, and processing circuitry, which is configured to control the operation of the switch device in accordance with the at least one operational parameter detected by the detection circuitry, and a plurality of detection contact surfaces for detecting the at least one operational parameter of the switch device. Further, the method comprises the step of conductively coupling the assembled circuit to a bus bar arrangement, which comprises an input bus bar and an output bus bar, wherein the plurality of detection contacts are pressed to corresponding contact surfaces being provided on the input bus bar and on the output bus bar, so as to abut against the corresponding contact surfaces, and conductively coupling the input bus bar to a first terminal of the switch device and the output bus bar to a second terminal of the switch device.

Throughout this document, the term "terminal" is meant to describe a point at which a conductor from an electric device, an electric circuit or an electric component ends, and where a point is provided for electrically connecting an external electric device, an external electric circuit or an external electric component to this conductor. Further, the terms "electrically connected" and "conductively coupled" describe the establishing of an electrical connection between at least two electric devices, electric components or electric conductors, which allows the flow of electric current. Hereby the electrical connection should not be restricted to a direct coupling of the terminals of the at least two electric devices, electric components or electric conductors, but other electric devices, electric components or electrical conductors may be coupled in between.

The accompanying drawings are incorporated into the specification and form a part of the specification to illustrate several examples of the present disclosure. These drawings, together with the description serve to explain the principles of the disclosure. The drawings are merely for the purpose of illustrating the preferred and alternative examples of how the disclosure can be made and used, and are not to be construed as limiting the disclosure to only the illustrated and described examples. Furthermore, several aspects of the examples may form-individually or in different combinations-solutions according to the present disclosure. The following described examples thus can be considered either alone or in an arbitrary combination thereof. Further features and advantages will become apparent from the following more particular description of the various examples of the disclosure, as illustrated in the accompanying drawings, in which like references refer to like elements, and wherein:
- **FIG. 1**: shows a schematic perspective view of an exemplary battery control unit;
- **FIG. 2**: shows another schematic perspective view of the exemplary battery control unit;
- **FIG. 3**: shows a schematic exploded view of the exemplary battery control unit;
- **FIG. 4**: shows a schematic bottom view of the exemplary battery control unit;
- **FIG. 5**: shows a schematic perspective view of a circuit board and an exemplary bus bar arrangement before attachment;
- **FIG. 6**: shows another schematic perspective view of the circuit board and the exemplary bus bar arrangement before attachment;
- **FIG. 7**: shows a schematic perspective view of the circuit board and the exemplary bus bar arrangement after attachment;
- **FIG. 8**: shows a schematic block diagram of an exemplary assembled circuit.

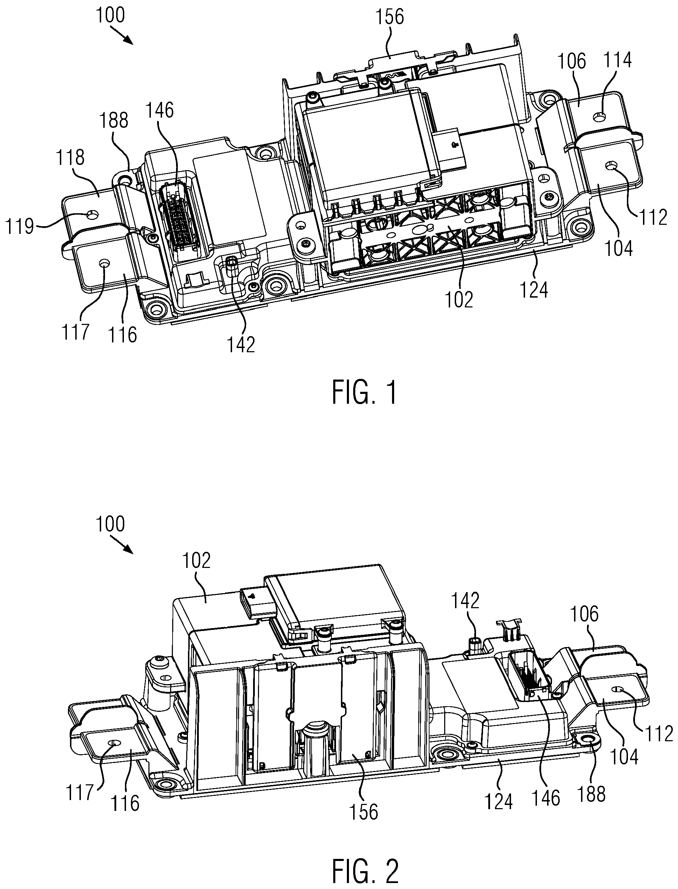

The present disclosure will now be further explained referring to the Figures, and firstly referring to Figs. 1 and 2. Figs. 1 and 2 show schematic perspective views of an exemplary battery control unit 100. As will become apparent from the following detailed description, the battery control unit 100 is an apparatus, which by its specific design allows for abolishing the need for providing cable connections between a battery control unit of a battery management system, which sometimes is signified as a (smart) battery sensor and controls operation of a (HV) battery, and the detection contacts of a power supply system, which is supplied by the (HV) battery. In an application scenario exemplarily described in the following, the battery control unit 100 is used in a power supply system of an electric vehicle for controlling the power supply of electric loads like a drivetrain of the electric vehicle, which are supplied at a predetermined high voltage in a range between 400 V and 1000 V or at an even higher voltage. However, the battery control unit 100 may also be used in other application scenarios, like the storage and/or supply of high voltage energy in one or a plurality of high voltage batteries, like an energy storage system used in an electrical power grid, or in application scenarios that require lower voltages than 400 V.

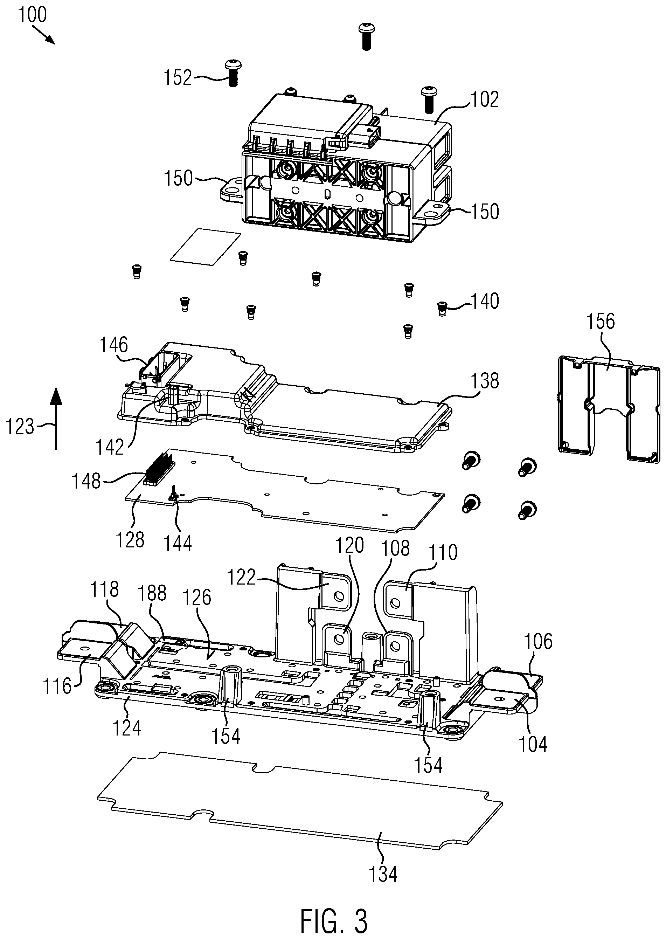

The battery control unit 100 comprises a switch device 102, which in the illustrated example is a contactor device, having the function of a two-pole contactor. A pair of input bus bars 104 and 106 is conductively coupled at respective end regions 108 and 110 (see Fig. 3) of the input bus bars 104 and 106 to first and second input terminals of the switch device 102. The input bus bars 104 and 106 respectively comprise input connection terminals 112 and 114 for connecting the high potential side and the low potential side of a high voltage battery (not shown). A pair of output bus bars 116 and 118 is conductively coupled at respective end regions 120 and 122 (see Fig. 3) of the output bus bars 116 and 118 to first and second output terminals of the switch device 102. The output bus bars 116 and 118 respectively comprise output connection terminals 117 and 119 for connecting the high potential side and the low potential side of a high voltage DC link (not shown), which is connected to the electric loads of the power supply system or to a charger. The bus bars 104, 106 116 and 118 of the battery control unit 100 are formed of an electrically conductive material with a high specific electrical conductivity, like copper or aluminum.

The switch device 102 is configured to electrically connect or disconnect the HV battery, which is electrically connected to the input connection terminals 112 and 114, to and from the HV DC link, which is electrically connected to the output connection terminals 117 and 119. In particular, based on control commands received from the control circuitry of the battery control unit 100, which is described later, the switch device 102 switches between an open state and a closed state. In the closed state, the current-carrying contacts of the switch device 102 are in contact, so that current flow through the switch device 102 from the HV battery to the HV DC link (or vice versa) is allowed. In the open state, the current-carrying contacts of the switch device 102 are isolated from each other, so that current flow through the switch device 102 from the HV battery to the HV DC link (or vice versa) is interrupted.

While the switch device 102 of the illustrated example is a contactor, which is capable of switching high DC voltages up to 900 V and DC currents up to 25 kA, depending on application requirements other switch devices, like other circuit breakers for high voltage applications or semiconductor switches for low voltage applications, may be implemented instead. In addition, the number of input bus bars and output bus bars may vary from the illustrated number of two input bus bars and two output bus bars depending on the configuration requirements of the switch device 102. Especially, it is possible that the battery control unit 100 may comprise a single-pole switch (or contactor) as the switch device 102, so that only one input bus bar and one output bus bar are installed for connecting the terminals of the single-pole switch (or contactor) to the respective input connection terminal and the respective output connection terminal. On the other hand, in cases where the switch device 102 is a multipole switch (or contactor) or where the battery control unit 100 comprises a plurality of switch devices 102, the bus bar arrangement of the battery control unit 100 comprises a plurality of input bus bars and output bus bars to connect all the terminals of the one or more switch device(s) 102 to input connection terminals and output connection terminals of the battery control unit 100.

The internal structure of the battery control unit 100 is illustrated by the schematic exploded view of Fig. 3. For simplifying the following description, in the following a surface, which faces in the same direction as the arrow 123 is signified as the "top surface" of an element, and a surface, which faces in a direction opposite to the arrow 123 is signified as the "bottom surface" of the element. It should be kept in mind that these terms are only used for the purpose of facilitating the description of the respective features and their relative orientation within the battery control unit 100 and should not be construed as limiting the claimed invention or any of its components to a particular spatial orientation.

As illustrated in Fig. 3, the bus bar arrangement, which is formed by the pair of input bus bars 104 and 106 and the pair of output bus bars 116 and 118 is overmolded with an insulating plastic, in particular a thermosetting polymer, such that the insulating plastic forms a bus bar housing element 124, which houses and carries the bus bars of the bus bar arrangement in bus bar holding portions. The bus bar housing element 124 provides, besides the bus bar housing portions, which hold the bus bars of the bus bar arrangement, on its top surface 126, i.e. the surface adverse to the bus bar housing portions, a supporting surface for a circuit board 128, on which the control circuitry of the battery control unit 100 is installed as an assembled circuit 130 (described later).

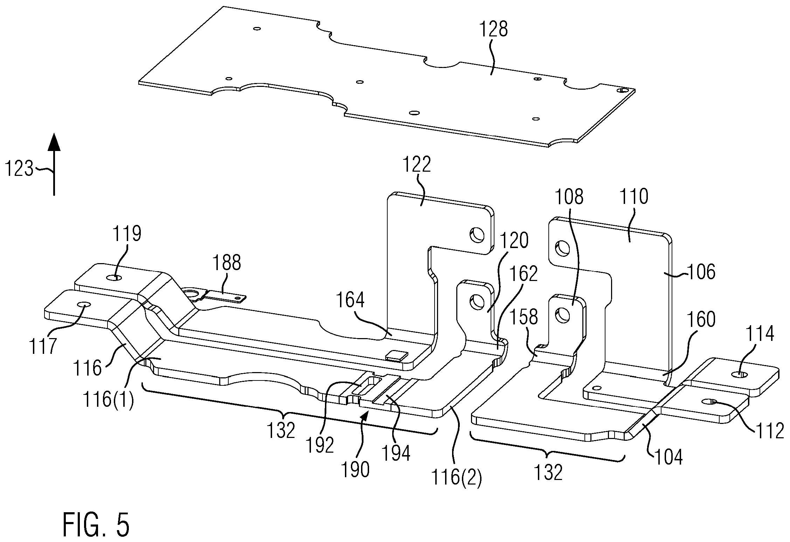

Accordingly, the bus bar housing element 124 is disposed between the bus bars of the bus bar arrangement and the circuit board 128 and isolates the assembled circuit 130 from the input bus bars 104 and 106 and from the output bus bars 116 and 118. Only areas where detection contacts of the assembled circuit 130 are provided and are pressed against corresponding contact surfaces of the input bus bars 104 and 106 and of the output bus bars 116 and 118 are exposed, so as to allow to press the detection contacts of the assembled circuit 130 onto the corresponding detection surfaces for making an electric connection. By its specific design, the bus bar housing element 124 serves as a spacer, which holds the circuit board 128 with a constant distance to main body portions 132 (see Fig. 5) of the input bus bars 104 and 106 and of the output bus bars 116 and 118, which extend below the circuit board 128. Positioning posts can be disposed to protrude from the top surface of the bus bar housing element 124 to simplify positioning and holding of the circuit board 128. The positioning posts can be inserted into corresponding positioning holes of the circuit board 128.

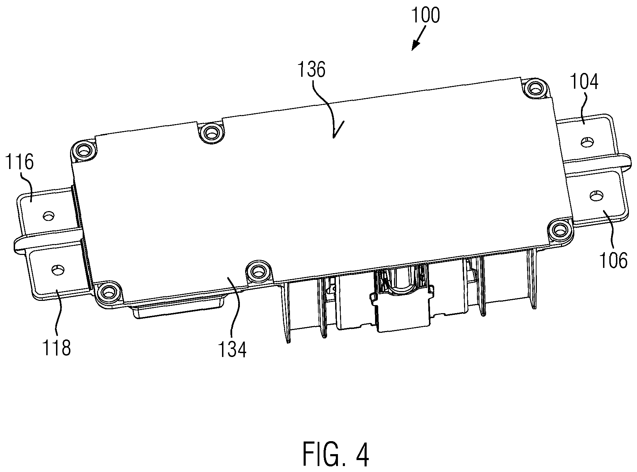

In order to prevent arcing between the bus bars of the bus bar arrangement, the bottom surface of the input bus bars 104 and 106 and of the output bus bars 116 and 118 is covered with an isolating bottom cover plate 134, which is fixed to the bus bar housing element 124, for example by injection molding or other suitable techniques known in the art. The bottom cover plate 134 is formed of an insulating material with a good thermal conductivity. The bottom surface of the bottom cover plate 134 forms a cooling surface 136, which acts as a thermal interface of the battery control unit 100, for example with a cooling system of a vehicle. As illustrated in Fig.4, in order to enlarge the cooling surface 136 of the battery control unit 100 and improve the thermal management of the battery control unit 100 and the heat transport away from the bus bars, the bottom cover plate 134 can correspond to the complete bottom surface of the battery control unit 100.

To protect the assembled circuit 130 from external influences, like dust and water or other fluids, the circuit board 128 and the assembled circuit 130 are encapsulated in a top cover 138. The top cover 138 is designed to hold the circuit board 128 on the supporting surface of the bus bar housing element 124. For providing a firm hold of the circuit board 128 and protecting the circuit board from external shocks and vibrations, the top cover 138 is fixed to the bus bar housing element 124 by first attachment members 140, here exemplified as screws, such that the circuit board 128 is sandwiched between the bus bar housing element 124 and the top cover 138.

For allowing the control circuitry of the battery control unit 100 to communicate with at least one cell monitoring unit, which measures and monitors parameters of the HV battery connected to the battery control unit 100, the top cover 138 comprises a first connector 142, which houses a first communication interface 144. In this manner, the control circuitry of the battery control unit 100 can receive battery parameters, like cell voltages and cell temperatures of the individual battery cells of the HV battery, from the at least one cell monitoring device or can control balancing of the voltages of the battery cells of the HV battery by activating active or passive cell balancing circuits of the at least one cell monitoring device. In the present example, the first communication interface 144 is an isoSPI (isolated Serial Port Interface) interface and allows the control circuitry of the battery control unit 100 to perform communication with the at least one cell monitoring device by using an isoSPI protocol. Alternatively, the first communication interface 144 may be an interface of a CAN (Controller Area Network) bus, or may be an Ethernet interface. However, also other known on-board networks and suitable industrial communication protocols may be supported. In particular, the first communication interface 144 may be a wireless interface and may be configured to perform wireless communication with the at least one cell monitoring unit instead of performing communication via cable connection.

For allowing the control circuitry of the battery control unit 100 to communicate with an external controller, such as a vehicle ECU or a superordinate controller of a power grid, which supervises the operation of battery control unit 100 and of the connected HV battery, the top cover 138 comprises a second connector 146, which houses a second communication interface 148. In this manner, the control circuitry of the battery control unit 100 can, for example, receive control commands for controlling the operation of the switch device 102 from the external controller. The second communication interface 148 is, for example, an interface to a CAN (Controller Area Network) bus allowing the control circuitry of the battery control unit 100 to perform communication with the external controller by a CAN protocol (like CAN, CANFD or CAN Extended). Alternatively, the second communication interface 148 can be a LIN (Local Interconnect Network) interface, a FlexRay interface, an isoSPI (isolated Serial Port Interface) interface or an Ethernet interface, thus allowing communicating with the external controller via the respective communication protocol.

The switch device 102 is installed on top of the top cover 138 of the assembled circuit 130, such that the assembled circuit 130, which is encapsulated between the bus bar housing element 124 and the top cover 138, is disposed between the switch device 102 and the main body portions 132 of the bus bars of the bus bar arrangement. Accordingly, the circuit board 128 and the switch device 102 are disposed on a same base area, which is spanned by the main body portions 132 of the bus bars of the bus bar arrangement, in the illustrated example the input bus bars 104 and 106 and by the output bus bars 116 and 118, so that the space requirements of the battery control unit 100 can be reduced. For firmly attaching the switch device 102, projecting mounting portions 150 of the switch device are fixed by second attachment members 152 to mounting studs 154, which are formed, in particular integrally formed, with the bus bar housing element 124, and which extend upwards from a base plane of the bus bar housing element 124.

In the exemplary implementation of the battery control unit 100 shown in Fig. 3, the end regions 108 and 110 of the input bus bars 104 and 106 and the end regions 120 and 122 of the output bus bars 116 and 118 comprise cut-outs, which are screwed to the corresponding input terminals and the output terminals of the switch device 102 to conductively couple the bus bars of the bus bar arrangement to the switch device 102. In alternative implementations, the bus bars of the bus bar arrangement to the switch device 102 can be conductively coupled with the corresponding terminals by welding, soldering or any other suitable connection method known in the art. For providing touch-proof protection against electric shocks, after conductively coupling the bus bars of the bus bar arrangement with the input and output terminals of the switch device 102 a protection plate 156 is mounted on the outside parts of the end regions 108 and 110 of the input bus bars 104 and 106 and on the outside parts of the end regions 120 and 122 of the output bus bars 116 and 118, which are exposed by the bus bar housing element 124. Accordingly, after completely mounting the battery control unit 100, only the input connection terminals 112 and 114 and the output connection terminals 117 and 119 are accessible to connect the HV carrying parts to external electric components.

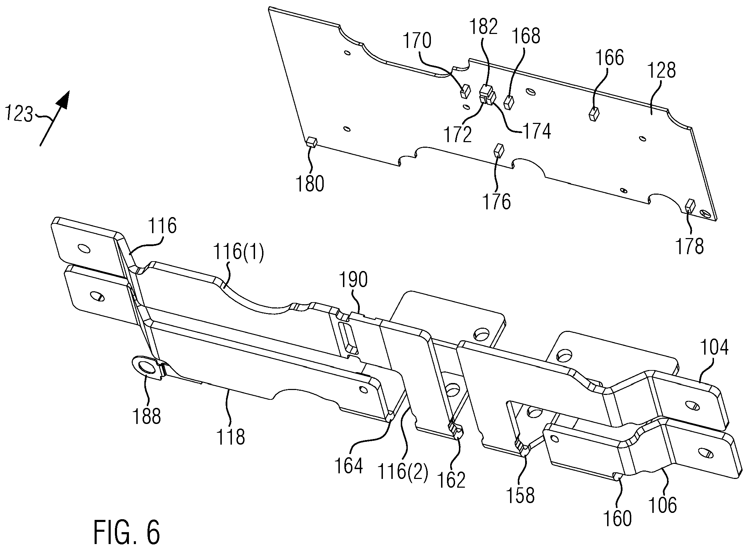

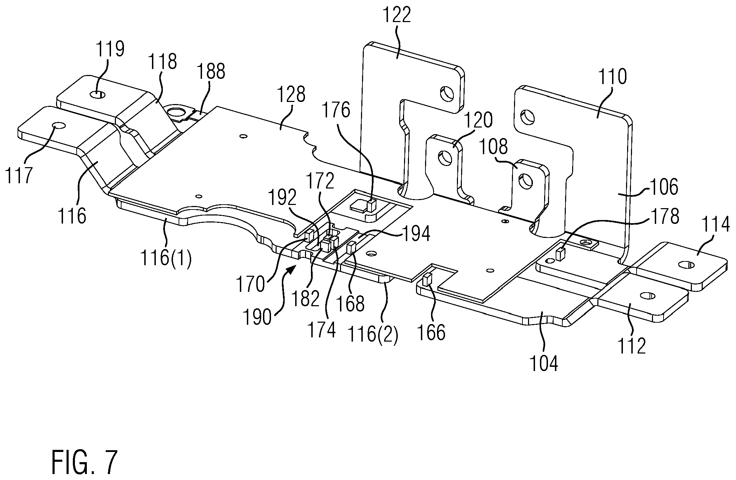

Figs. 5 and 6 show schematic perspective views of the circuit board 128, on which the assembled circuit 130, is mounted, and of the bus bar arrangement of the battery control unit 100, before the circuit board is attached to the bus bars of the bus bar arrangement. Fig. 7 shows a schematic perspective views of the circuit board 128 and of the bus bar arrangement of the battery control unit 100, after attaching the circuit board 128 to the to the bus bars of the bus bar arrangement. In Fig. 7, the parts of the circuit board 128, which would hide the detection contacts of the assembled circuit 130 are not shown.

As illustrated in Fig. 5, the main body portions 132 of the two input bus bars 104 and 106 and of the two output bus bars 116 and 118, which carry the contact surfaces of the bus bar arrangement, extend in a same plane. In contrast thereto, the end regions of the input bus bars and of the output bus bars are bent upwards in direction towards the switching device 102, in order to allow for a space-saving connection of the switch device 102. This means that advantageously each of the bus bars of the bus bar arrangement comprises a bending between the main body portion and the end region. For example, in the illustrated configuration the input bus bar 104 comprises a bending 158 between the main body portion 132 and the end region 108, the input bus bar 106 comprises a bending 160 between the main body portion 132 and the end region 110, the output bus bar 116 comprises a bending 162 between the main body portion 132 and the end region 120, and the output bus bar 118 comprises a bending 164 between the main body portion 132 and the end region 122. In the illustrated example, the end regions of the input bus bars and of the output bus bars extend in a plane that is substantially orthogonal to the plane, in which the main body portions 132 of the input bus bars and of the output bus bars extend, which means that a bending angle between the main body portions and the end regions is approximately 90° for each of the input bus bars 104 and 106 and for each of the output bus bars 116 and 118. The specific bending angle can however be selected depending on application needs and any bending angle in a range between 45° and 135°, or preferably in a range between 70° and 110° may be selected. Further, in an alternative implementation of the battery control unit 100, the switch device 102 may be disposed at the side of the circuit board 128 instead of on top of the circuit board 128. In this alternative implementation it is also possible that the end regions of the bus bars extend in the same plane like the main body portions of the bus bars and the bus bars of the bus bar arrangement, and do not comprise the bending.

To facilitate the connection to the external electric components, the input connection terminals 112 and 114 and the output connection terminals 117 and 119 may be elevated above the plane, in which the main body portions 132 of the bus bars of the bus bar arrangement extend. Alternatively, the input connection terminals 112 and 114 and the output connection terminals 117 and 119 may extend in the same plane as the main body portions, or may be bend up in a similar manner as the end regions of the bus bars.

In order to simplify the connection between the assembled circuit 130, which is mounted on the circuit board 128, and the input bus bars 104 and 106 and the output bus bars 116 and 118 of the bus bar arrangement, the assembled circuit 130 comprises a plurality of detection contacts 166, 168, 170, 172, 174, 176, 178, 180 and 182 which are pressed against corresponding contact surfaces of the bus bars of the bus bar arrangement (see Figs. 6 and 7). The plurality of detection contacts 166, 168, 170, 172, 174, 176, 178, 180 and 182 are formed of spring-loaded contacts, which abut against the corresponding contact surfaces when making contact between the bus bars of the bus bar arrangement and the assembled circuit 130. In this manner, the elasticity of the spring-loaded contacts allows to compress the plurality of detection contacts 166, 168, 170, 172, 174, 176, 178, 180 and 182 and helps in compensating fabrication tolerances between the bus bars of the bus bar arrangement. Accordingly, a reliable contact between each of the bus bars of the bus bar arrangement and the assembled circuit 130 can be guaranteed even if the contact surfaces of the bus bars are arranged at slightly deviating heights. For example, the plurality of detection contacts 166, 168, 170, 172, 174, 176, 178, 180 and 182 are formed of so called "gaskets", by a strap-shaped metal band, which is filled with an insulating foam, so that the insulating foam is compressed, when the plurality of detection contacts 166, 168, 170, 172, 174, 176, 178, 180 and 182 are pressed onto the bus bars of the bus bar arrangement.

In the illustrated exemplary implementation, the corresponding contact surfaces are provided on the top sides of the input bus bars 104 and 106 and the top surfaces of the output bus bars 116 and 118, which means that the corresponding contact surfaces are integrally formed with the top surfaces of the input bus bars 104 and 106 and the top surfaces of the output bus bars 116 and 118, which face towards the assembled circuit 130. Alternatively, the input bus bars 104 and 106 and the output bus bars 116 and 118 may be formed with protruding extension arms, which each carry one of the contact surfaces. In this example, the plurality of detection contacts 166, 168, 170, 172, 174, 176, 178, 180 and 182 of the assembled circuit 130 may be screwed against the corresponding contact surfaces of the bus bar arrangement instead of having the form of spring-loaded or compressible contact elements.

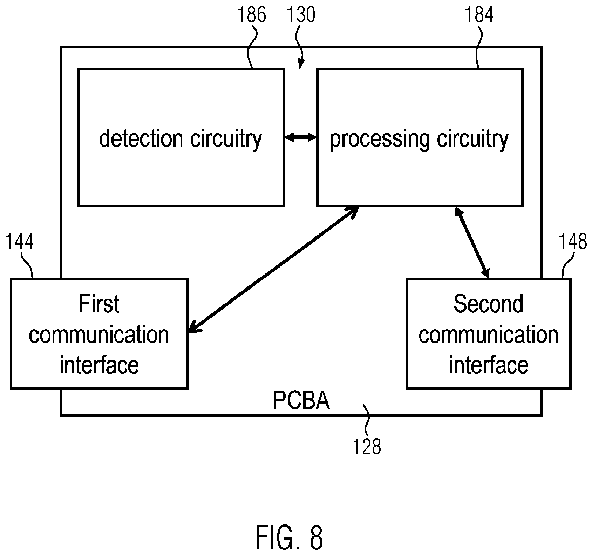

Fig.8 shows a schematic block diagram of the assembled circuit 130, which is mounted on the circuit board 128. The assembled circuit 130 comprises a processing circuitry 184, which controls the operation of the switch device 102 as part of the control circuitry of the battery control unit 100 in order to allow or to interrupt current flow through the switch device 102. The switch device 102, and in particular an internal controller of the switch device 102, is for example connected to the assembled circuit 130 by a wired connection, such as an "Y wire" harness, so that the processing circuitry 184 can control the operation of the switch device 102. Hereby, the processing circuitry 184 controls the operation of the switch device 102 in accordance with one or more operational parameters, which are detected by a detection circuitry 186 of the assembled circuit 130 or in accordance with control commands received by the processing circuitry from an external controller through the second communication interface 148. Alternatively, the operational parameter may be at least one of a plurality of battery parameters received by the processing circuitry 184 through the first communication interface 144. In particular, as will be described later in more detail, the operational parameter can be at least one of a voltage dropping across the contacts of the switch device 102, which corresponds to a voltage dropping between the input bus bar 104 and the output bus bar 116 or a voltage dropping between the input bus bar 106 and the output bus bar 118, a battery current, which corresponds to a current flowing through the switch device 102, a temperature of a temperature sensor of the assembled circuit 130, or a leakage path resistance, which exists between a ground terminal (or voltage reference terminal) 188 and at least one of the bus bars of the battery control unit.

The circuitry of the assembled circuit 130 is mounted on the circuit board 128, to form an integrated component. Hereby the term integrated component especially refers to the fact, that all components of the assembled circuit 130 are packaged together as a single compact component encapsulated by the bus bar housing element 124 and the top cover 138. For example, a printed circuit board (PCB) is used as the circuit board 128, and by mounting the assembled circuit 130 on the PCB, the PCB becomes an assembled printed circuit board (PCBA). Notably, the functionalities of each circuit of the assembled circuit 130 may be realized by software, hardware, or software in cooperation with hardware. Furthermore, each circuit of the assembled circuit 130 can be realized as a dedicated integrated circuit and the dedicated integrated circuits are assembled to form the assembled circuit. Alternatively, the functionalities of each circuit may be integrated into a common integrated circuit, which forms the assembled circuit 130. Alternatively, one or more circuits of the assembled circuit may be realized by using general-purpose processors, special-purpose processors, or FPGAs (Field Programmable Gate Array) that can be programmed. Furthermore, the voltage detection circuits of the assembled circuit 130 may be formed by dedicated analog to digital converters (ADC-converters), or may be formed by a single ADC converter, which performs the individual voltage detections as described above in a serial order.

Referring back to Figs. 5 to 7, the plurality of detection contacts 166, 168, 170, 172, 174, 176, 178, 180 and 182 comprise different detection contact pairs, which enable the detection circuitry 186 of the assembled circuit 130 to detect operational parameters of the battery control unit 100, and in particular of the switch device 102, as will become apparent from the following examples.

In a first example, the detection contact 166, which abuts against a corresponding contact surface of the input bus bar 104, and the detection contact 168, which abuts against a corresponding contact surface of the output bus bar 116, form a first pair of voltage detection contacts 166 and 168. The detection circuitry 186 comprises a first detection circuit, which is configured to detect a voltage between the first pair of voltage detection contacts 166 and 168 being indicative of the voltage dropping across the switch device 102 between the input bus bar 104 and the output bus bar 116 as one of the operational parameters of the switch device 102.

In addition, in the first example the detection contact 178, which abuts against a corresponding contact surface of the input bus bar 106, and the detection contact 176, which abuts against a corresponding contact surface of the output bus bar 118, may form a second pair of detection contacts 176 and 178. The first detection circuit may be configured to determine a voltage between the second pair of detection contacts 176 and 178 being indicative of the voltage dropping across the switch device 102 between the input bus bar 106 and the output bus bar 118 as one of the operational parameters of the switch device 102.

On the basis of the detected voltage drop(s), the processing circuitry 184 is configured to determine the voltage dropping across the contacts of the switch device 102, and to control the opening and closing of the switch device 102 based on the determined voltage(s) dropping across the contacts of the switch device 102. For example, due to possible current peaks, which may harm components electrically connected to the HV DC bus, like a DC link capacitor, the processing circuitry 184 may only switch the switch device 102 to the closed state, if the determined contactor voltage is equal or smaller than a predetermined voltage threshold, but will prohibit switching the switch device 102 to the closed state, if the determined contactor voltage is larger than the predetermined voltage threshold. As an optional implementation, the processing circuitry 184 may control a pre-charging circuit to pre-charge the DC link capacitor, before switching the switch device 102 to the closed state.

In a second example, the bus bar arrangement comprises at least one resistor element having a predefined resistance, and the processing circuitry is configured to determine a current, which flows through the resistance element. For example, as shown in Figs. 5-7, the output bus bar 116 is divided into two halves 116(1) and 116(2) and a resistor arrangement 190 in form of a double shunt sensor is electrically connected between the two halves 116(1) and 116(2) of the output bus bar 116, so that the resistor arrangement 190 is integrally formed with the output bus bar 116.

In the illustrated example, the resistor arrangement 190 comprises a first electrically conductive connection element, which is welded or soldered to the first half 116(1) of the output bus bar 116, and a second electrically conductive connection element, which is welded or soldered to the second half 116(2) of the output bus bar 116. The first electrically conductive connection element and the second electrically conductive connection element are formed of a similar or same material like the bus bars of the bus bar arrangement, i.e. preferably of copper or aluminum. A first resistance element 192 is arranged between the first electrically conductive connection element and an intermediate connection element of the resistor arrangement 190. A second resistance element 194 is arranged between the intermediate connection element of the resistor arrangement 190 and an intermediate connection element of the resistor arrangement 190. In the illustrated example, the first resistance element 192 is formed of the same material as the first electrically conductive connection element and the intermediate connection element with a specific geometrical shape, which allows to define the resistance value of the first resistance element 192. For example, the first resistance element 192 can be designed to have a predefined resistance below 50 µOhm, while preferably the resistance is below 10 µOhm in order to reduce the heating losses in the first resistance element 192. The second resistance element 194 is formed of a first resistance material, such as a manganin alloy, wherein in particular CuMn10Ni4 and CuMn12Ni2 and CuMn14Ni2 and CuZn15Mn150Al can be named as examples, or a similar suitable resistance material known in the art, which has a lower specific electrical conductivity than the conductive material of the first electrically conductive connection element and the second electrically conductive connection element. Hereby, the second resistance element 194 typically is designed to have a predefined resistance in the range of 10 - 50 µOhm.

In the second example, the detection contact 170, which abuts against a corresponding contact surface of the first electrically conductive connection element of the resistor arrangement 190 (or alternatively against a corresponding contact surface of the first half 116(1) of the input bus bar 116), and the detection contact 172, which abuts against a corresponding contact surface of the intermediate connection element of the resistor arrangement 190, form a first pair of current detection contacts 170 and 172. The detection circuitry 186 comprises a second detection circuit, which is configured to detect a voltage between the first pair of current detection contacts 170 and 172, which is indicative of the voltage dropping across the first resistance element 192.

On the basis of the detected voltage drop, the processing circuitry 184 is configured to determine battery current, which corresponds to a current flowing through the switch device 102, by using equation (1), ${I}_{bat} = \frac{{V}_{Res}}{R} ,$ (1) wherein the processing circuitry 184 uses the detected voltage between the first pair of current detection contacts 170 and 172 as V_{Res} and the predefined resistance of the first resistance element 192 as R.

In addition, the second example, the battery current can be redundantly determined by means of the second resistance element 194. For this purpose, the detection contact 168, which abuts against a corresponding contact surface of the second electrically conductive connection element of the resistor arrangement 190 (or alternatively against a corresponding contact surface of the second half 116(2) of the input bus bar 116), and the detection contact 174, which abuts against a corresponding contact surface of the intermediate connection element of the resistor arrangement 190, form a second pair of current detection contacts 168 and 174. Further, the second detection circuit is configured to detect a voltage between the second pair of current detection contacts 168 and 174, which is indicative of the voltage dropping across the second resistance element 194.

On the basis of the detected voltage drop, the processing circuitry 184 is configured to redundantly determine the battery current, which corresponds to a current flowing through the switch device 102, by using equation (1) wherein the processing circuitry 184 uses for the redundant determination the detected voltage between the second pair of current detection contacts 168 and 174 as V_{Res} and the predefined resistance of the second resistance element 194 as R.

Based on the determined battery current, the processing circuitry 184 controls the operation of the switch device 102 and optionally also controls the activation of an overcurrent protection device being integrated into the switch device 102. For example, the processing circuitry may bring the switch device in an open state, if the processing circuitry determines that the battery current exceeds a predetermined first current threshold for a predetermined time. Further, due to contact welding in case of extreme overcurrent, it may not be possible to separate the contacts of the switch device 102, when battery current exceeds a second predetermined current threshold, which is larger than the first predetermined current threshold. Accordingly, if the control circuit determines that the determined contactor current is larger or equal to the second predetermined current threshold, the processing circuitry 184 issues an activation signal to activate the overcurrent device to interrupt the overcurrent.

Notably, in the second example the design of the resistor arrangement 190 is not limited to the above described double shunt sensor geometry. In particular, instead double shunt sensors with two resistance elements being formed of manganese or a similar resistance material may be used. Similar, instead of using a double-shunt sensor it is also possible to use a single shunt sensor with a single resistance element or a plurality of single shunt sensors. Furthermore, the second example is not limited to connecting the resistor arrangement 190 on the output bus bar 116, but the resistor arrangement 190 may be connected to one of the other input bus bars 104 and 106 or the output bus bar 118 instead. Furthermore, it is also possible that separate individual resistor arrangement are connected to more than one of the bus bars of the bus bar arrangement. In all of these cases, the configuration of the detection contacts, which serve as current detection contacts, is adapted according to the geometry of the resistor arrangement(s), such as to enable a detection and determination of the battery current through the resistor arrangement(s).

In a third example, the assembled circuit 130 comprises a temperature sensor, such as an NTC thermistor or other suitable temperature sensor, which is thermally coupled by one of the plurality of detection contacts with at least one of the bus bars of the bus bar arrangement. In the third example, for example the detection contact 182, which abuts against a corresponding contact surface of the intermediate connection element of the resistor arrangement 190 forms a temperature detection contact, which enables the temperature sensor to sense the temperature of the resistor arrangement 190. Of course, it is alternatively also possible that another one of the plurality of detection contacts 166, 168, 170, 172, 174, 176, 178, 180 and 182, can function as temperature detection contact, which is thermally coupled to the temperature sensor, so that the temperature sensor senses the temperature at another location of the bus bar arrangement. However, if the detection contact 182 forms the temperature detection contact, the processing circuitry 184 can additionally perform a TCR (temperature coefficient ratio) correction of the resistance of the first resistance element 192 and of the second resistor element 194 and can accordingly enhance the accuracy of the battery current determination.

The processing circuitry 184 determines the temperature of the temperature sensor and controls the state of the switch device based on the sensed temperature. For example, if the processing circuitry 184 determines that the temperature of the temperature sensor exceeds a temperature threshold, which indicates an overheating of the bus bars of the bus bar arrangement by high currents, the processing circuitry 184 brings the switch device 102 in the open state to interrupt the current. Optionally, the processing circuitry 184 may in addition control the activation of an overcurrent protection device being integrated into the switch device 102, if the processing circuitry 184 determines that the temperature of the temperature sensor exceeds the temperature threshold for longer than a predetermined time.

In a fourth example, the bus bar arrangement comprises the ground terminal 188, which is electrically isolated from the input bus bars 104 and 106 and from the output bus bars 116 and 118. The ground terminal 188 can be electrically connected to a ground potential, like the chassis of a vehicle. For example, the detection contact 180 abuts against the ground terminal 188 and forms a leakage path resistance detection contact, which enables the detection circuitry 186 to detect a leakage path between the ground terminal 188 and the resistor arrangement 190. For this purpose, the detection circuitry 186 comprises a third detection circuit which is configured to detect the leakage path resistance between at least one of the input bus bars 104 and 106 and the output bus bars 116 and 118 and the ground terminal 188. Possible configurations of the third detection circuitry are described in detail, for example, with reference to Figs. 1 to 4 of European patent application EP 3 660 520 A1 and are omitted here, but of course also other suitable leakage path detection circuits and methods known in the art may be implemented.

The processing circuitry 184 determines the leakage path resistance and based on the result of the determination of the leakage path resistance, the processing circuitry 184 controls the operation of the switch device 102. In particular, the processing circuitry 184 switches the switch device 102 to the open state, if the processing circuitry 184 determines that the leakage path resistance between any bus bar of the bus bar arrangement and the ground terminal 188 is equal or smaller than a predetermined resistance threshold. Optionally, the processing circuitry 184 may in addition control the activation of an overcurrent protection device being integrated into the switch device 102, if the processing circuitry 184 determines that the leakage path resistance between any bus bar of the bus bar arrangement and the ground terminal 188 is equal to or smaller than the predetermined resistance threshold.

For assembling the battery control unit 100, in a first step, the assembled circuit 130 is mounted on the circuit board 128 to form an assembled circuit board and the assembled circuit board is housed in the top cover 138. The assembled circuit board is then conductively coupled with the input bus bars 104 and 106, the output bus bar 116 and 118 and the ground terminal 188, which are overmolded by the bus bar housing element 124. For this purpose, the plurality of detection contacts 166, 168, 170, 172, 174, 176, 178, 180 and 182 are fitted through the openings of the bus bar housing element 124, which expose the corresponding contact surfaces of the bus bars 104, 106, 116 and 118 and the ground terminal 188, and are pressed against the corresponding contact surfaces until the plurality of detection contacts 166, 168, 170, 172, 174, 176, 178, 180 and 182 abut against the corresponding contact surfaces. In a next step, the top cover 138 of the assembled circuit is fixed to the bus bar housing element 124 by the first attachment members 140. The terminals of the switch device 102 are conductively coupled to the respective end regions 108 and 110 of the input bus bars 104 and 106 and to the respective end regions 120 and 122 of the output bus bars 116 and 118 and the switch device 102 is fixed by the second attachment members 152 to the mounting studs 154.

While not being shown in the Figures, the present disclosure also relates to a power supply system, which comprises the battery control unit 100 and a battery being electrically connected to the input connection terminals 112 and 114. For example, the battery control unit 100 can be integrated into a battery pack, and the assembled circuit 130 can directly monitor the operational parameters of the battery of the battery pack and of the switch device 102 and can control opening and closing of the switch device 102 accordingly.

### REFERENCE NUMERALS

| | |
|---|---|
| 100 | Battery control unit |
| 102 | Switch device |
| 104, 106 | Input bus bar |
| 108, 110 | End region of input bus bars |
| 112, 114 | Input connection terminals |
| 116, 118 | Output bus bars |
| 117, 119 | Output connection terminals |
| 120, 122 | End region of output bus bars |
| 123 | Directional arrow |
| 124 | Bus bar housing element |
| 126 | Top surface of the bus bar housing element |
| 128 | Circuit board |
| 130 | Assembled circuit |
| 132 | Main body portions of the bus bars |
| 134 | Bottom cover plate |
| 136 | Cooling surface |
| 138 | top cover |
| 140 | First attachment member |
| 142 | First connector |
| 144 | First communication interface |
| 146 | Second connector |
| 148 | Second communication interface |
| 150 | Mounting portions |
| 152 | Second attachment members |
| 154 | Mounting studs |
| 156 | Protection plate |
| 158, 160, 162, 164 | Bending |
| 166, 168, 170, 172, 174, 176, 178, 180, 182 | Detection contacts |
| 184 | Processing circuitry |
| 186 | Detection circuitry |
| 188 | Ground terminal |
| 190 | Resistor arrangement |
| 192 | First resistance element |
| 194 | Second resistance element |

## Claims

1. A battery control unit (100) comprising:
a switch device (102), and
an assembled circuit (130), which is mounted on a circuit board (128), wherein the assembled circuit (130) includes
• detection circuitry (186), which is configured to detect at least one operational parameter of the switch device (102), and
• processing circuitry (184), which is configured to control the operation of the switch device (102) in accordance with the at least one operational parameter detected by the detection circuitry (186), and
• a plurality of detection contacts (166, 168, 170, 172, 174, 176, 178, 180, 182) for detecting the at least one operational parameter of the switch device (102); and
a bus bar arrangement, which comprises an input bus bar (104), which is conductively coupled to an input terminal of the switch device (102), and an output bus bar (116), which is conductively coupled to an output terminal of the switch device (102),
**characterized in that** the circuit board (128) is disposed with respect to the bus bar arrangement such that the plurality of detection contacts (166, 168, 170, 172, 174, 176, 178, 180, 182) abut against corresponding contact surfaces being provided on the input bus bar (104) and on the output bus bar (116).

2. The battery control unit (100) according to claim 1, wherein the input bus bar (104) and the output bus bar (116) each comprise a main body portion (132), which extends substantially parallel to the circuit board (128),
wherein an end region (108) of the input bus bar (104), which is conductively coupled with the input terminal of the switch device (102), is bent with respect to the main body portion (132) of the input bus bar (104), and
wherein an end region (120) of the output bus bar (116), which is conductively coupled with the output terminal of the switch device (102), is bent with respect to the main body portion (132) of the output bus bar (116).

3. The battery control unit (100) according to claim 2, wherein the circuit board (128) is disposed between the switch device (102) and a plane, which is spanned by the main body portions (132) of the input bus bar (104) and of the output bus bar (116).

4. The battery control unit (100) according to one of the preceding claims, further comprising a bus bar housing element (124), which houses the input bus bar (104) and the output bus bar (116), wherein the bus bar housing element (124) isolates the input bus bar (104) and the output bus bar (116) from the assembled circuit (130) and exposes the contact surfaces of the input bus bar (104) and of the output bus bar (116) to the plurality of detection contacts (166, 168, 170, 172, 174, 176, 178, 180, 182).

5. The battery control unit (100) according to one of the preceding claims, wherein a bottom surface of the bus bar housing element (124), which faces away from the assembled circuit (130), is covered with an insulating bottom cover (134), which is formed of an insulating heat conducting material, and wherein an external surface of the insulating bottom cover (134) forms a cooling surface (136) for cooling the input bus bar (104) and the output bus bar (116).

6. The battery control unit (100) according to one of the preceding claims, wherein the plurality of detection contacts (166, 168, 170, 172, 174, 176, 178, 180, 182) are formed of compressible contact elements, in particular wherein the plurality of detection contacts are each formed of a strap-shaped metal band, which is filled with an insulating foam.

7. The battery control unit (100) according to one of the preceding claims, wherein the corresponding contact surfaces of the input bus bar (104) and of the output bus bar (116) are integrally formed with the top surfaces of the input bus bar (104) and of the output bus bar (116), which face towards the assembled circuit (130).

8. The battery control unit (100) according to one of the preceding claims, wherein a first one of the plurality of detection contacts (166) abuts against a corresponding contact surface being provided on the input bus bar (104) and a second one of the plurality of detection contacts (168) abuts against a corresponding contact surface being provided on the output bus bar (116), and
wherein the detection circuitry (186) comprises a first detection circuit, which is configured to detect a voltage dropping between the first one of the plurality of detection contacts (166) and the second one of the plurality of detection contacts (168), and
wherein the processing circuitry (184) is configured to determine a voltage value of the voltage dropping across the switch device (102) as an operational parameter of the switch device.

9. The battery control unit (100) according to one of the preceding claims,
wherein the bus bar arrangement comprises at least one resistor element (192) having a predefined resistance,
wherein a third one of the plurality of detection contacts (170) and a fourth one of the plurality of detection contacts (172) abut against corresponding contact surfaces of the bus bar arrangement, which are arranged for detecting a resistor voltage dropping across the resistor element (192), and
wherein the detection circuitry (186) comprises a second detection circuit, which is configured to detect the resistor voltage dropping across the resistor element (192) between the third one of the plurality of detection contacts (170) and the fourth one of the plurality of detection contacts (172), and
wherein the processing circuitry (184) is configured to determine a current value of a current flowing through the switch device (102) as the at least one operational parameter based on the detected resistor voltage, and
optionally, wherein the resistor element (192) is integrally formed with one of the input bus bar (104) and of the output bus bar (116).

10. The battery control unit (100) according to one of the preceding claims, wherein the assembled circuit (130) comprises a temperature sensor, which is thermally coupled with at least one of the input bus bar (104) and of the output bus bar (116) by at least one of the plurality of detection contacts (166, 168, 170, 172, 174, 176, 178, 180, 182),
wherein the processing circuitry (184) is configured to determine a temperature of the temperature sensor as an operational parameter of the switch device (102).

11. The battery control unit (100) according to one of the preceding claims,
wherein the bus bar arrangement further comprises a ground terminal (188), which is electrically isolated from the input bus bar (104) and from the output bus bar (116), for electrically connecting a ground potential,
wherein a fifth one of the plurality of detection contacts (180) abuts against a corresponding contact surface of the ground terminal (188),
wherein the detection circuitry (186) comprises a third detection circuit, which is configured to detect a third detection voltage, which is indicative of a leakage path resistance between the ground terminal (188) and one of the input bus bar (104) and of the output bus bar (116), and
wherein the processing circuitry (184) is configured to determine the leakage path resistance as an operational parameter of the switch device (102).

12. The battery control unit (100) according to one of the preceding claims, wherein the assembled circuit (130) comprises a first communication interface (144) for performing communication with at least one cell monitoring device, which monitors battery parameters of a high voltage battery, and
wherein the processing circuitry (184) is configured to control the operation of the switch device (102) in accordance with at least one battery parameter, which is received by the first communication interface (144) from the cell monitoring device, and/or
wherein the assembled circuit (130) comprises a second communication interface (148) for performing communication with an external controller, which is configured to control a high voltage battery, and
wherein the processing circuitry (184) is configured to control the operation of the switch device (102) in accordance with a control command, which is received by the second communication interface (148) from the external controller.

13. The battery control unit (100) according to one of the preceding claims, wherein the switch device (102) is configured to switch between an open state and a closed state, wherein in the open state current flow through the switch device (102) is interrupted, and in the closed state current flow through the switch device (102) is allowed, and
wherein the processing circuitry (184) is configured to switch the switch device in accordance with the at least one operational parameter detected by the detection circuitry (186), and/or
wherein the battery control unit (100) further comprises at least one overcurrent protection device, which is configured to prevent overcurrent from flowing through the switch device (102); and
wherein the processing circuitry (184) is configured to control the operation of the at least one overcurrent protection device in accordance with the at least one operational parameter detected by the detection circuitry (186).

14. A power supply system, which comprises at least one battery and the battery control unit (100) according to any of claims 1 to 13, wherein the at least one battery is conductively coupled to the switch device (102).

15. A method for assembling a battery control unit (100), the method comprising:
mounting an assembled circuit (130) on a circuit board (128), wherein the assembled circuit (130) includes
• detection circuitry (186), which is configured to detect at least one operational parameter of a switch device (102), and
• processing circuitry (184), which is configured to control the operation of the switch device (102) in accordance with the at least one operational parameter detected by the detection circuitry (186), and
• a plurality of detection contacts (166, 168, 170, 172, 174, 176, 178, 180, 182) for detecting the at least one operational parameter of the switch device (102);
**characterized by**
conductively coupling the assembled circuit (130) to a bus bar arrangement, which comprises an input bus bar (104) and an output bus bar (116), wherein the plurality of detection contacts (166, 168, 170, 172, 174, 176, 178, 180, 182) are pressed to corresponding contact surfaces being provided on the input bus bar (104) and on the output bus bar (116), so as to abut against the corresponding contact surfaces, and
conductively coupling the input bus bar (104) to a first terminal of the switch device (102) and the output bus bar (116) to a second terminal of the switch device (102).

## Patentansprüche

1. Batteriesteuereinheit (100), umfassend:
eine Schaltvorrichtung (102); und
eine bestückte Schaltung (130), die auf einer Leiterplatte (128) montiert ist, wobei die bestückte Schaltung (130) umfasst:
• eine Detektionsschaltung (186), die dazu eingerichtet ist, mindestens einen Betriebsparameter der Schaltvorrichtung (102) zu erfassen; und
• eine Verarbeitungsschaltung (184), die dazu eingerichtet ist, den Betrieb der Schaltvorrichtung (102) in Übereinstimmung mit dem mindestens einen von der Detektionsschaltung (186) erfassten Betriebsparameter zu steuern; und
• eine Mehrzahl von Detektionskontakten (166, 168, 170, 172, 174, 176, 178, 180, 182) zum Erfassen des mindestens einen Betriebsparameters der Schaltvorrichtung (102); und
eine Stromschienenanordnung, die eine Eingangsstromschiene (104), die leitend mit einem Eingangsanschluss der Schaltvorrichtung (102) gekoppelt ist, und eine Ausgangsstromschiene (116), die leitend mit einem Ausgangsanschluss der Schaltvorrichtung (102) gekoppelt ist, umfasst,
**dadurch gekennzeichnet, dass** die Leiterplatte (128) bezüglich der Stromschienenanordnung derart angeordnet ist, dass die Mehrzahl von Detektionskontakten (166, 168, 170, 172, 174, 176, 178, 180, 182) gegen entsprechende Kontaktflächen gedrückt wird, die an der Eingangsstromschiene (104) und an der Ausgangsstromschiene (116) vorgesehen sind.

2. Batteriesteuereinheit (100) nach Anspruch 1, wobei die Eingangsstromschiene (104) und die Ausgangsstromschiene (116) jeweils einen Hauptkörperabschnitt (132), der sich im Wesentlichen parallel zu der Leiterplatte (128) erstreckt, und einen Endbereich (108), der leitend mit dem Eingangsanschluss der Schaltvorrichtung (102) gekoppelt ist, umfassen, wobei der Endbereich (108) der Eingangsstromschiene (104) gegenüber dem Hauptkörperabschnitt (132) der Eingangsstromschiene (104) gebogen ist, und wobei ein Endbereich (120) der Ausgangsstromschiene (116), der leitend mit dem Ausgangsanschluss der Schaltvorrichtung (102) gekoppelt ist, gegenüber dem Hauptkörperabschnitt (132) der Ausgangsstromschiene (116) gebogen ist.

3. Batteriesteuereinheit (100) nach Anspruch 2, wobei die Leiterplatte (128) zwischen der Schaltvorrichtung (102) und einer Ebene angeordnet ist, die von den Hauptkörperabschnitten (132) der Eingangsstromschiene (104) und der Ausgangsstromschiene (116) aufgespannt wird.

4. Batteriesteuereinheit (100) nach einem der vorhergehenden Ansprüche, ferner umfassend ein Stromschienengehäuseelement (124), das die Eingangsstromschiene (104) und die Ausgangsstromschiene aufnimmt,
wobei das Stromschienengehäuseelement (124) die Eingangsstromschiene (104) und die Ausgangsstromschiene (116) von der bestückten Schaltung (130) isoliert und die Kontaktflächen der Eingangsstromschiene (104) und der Ausgangsstromschiene (116) für die Mehrzahl von Detektionskontakten (166, 168, 170, 172, 174, 176, 178, 180, 182) freilegt.

5. Batteriesteuereinheit (100) nach einem der vorhergehenden Ansprüche, wobei eine Unterseite des Stromschienengehäuseelements (124), die von der bestückten Schaltung (130) weg weist, mit einer isolierenden Bodenabdeckung (134) bedeckt ist, die aus einem Isoliermaterial gebildet ist, und wobei eine Außenfläche der isolierenden Bodenabdeckung (134) eine Kühlfläche (136) zum Kühlen der Eingangsstromschiene (104) und der Ausgangsstromschiene (118) bildet.

6. Batteriesteuereinheit (100) nach einem der vorhergehenden Ansprüche, wobei die Mehrzahl von Detektionskontakten (166, 168, 170, 172, 174, 176, 178, 180, 182) aus kompressiblen Kontaktelementen gebildet ist, insbesondere wobei die Mehrzahl von Detektionskontakten jeweils aus einem bandförmigen Metallband gebildet ist, das zur Hälfte mit einem Isolierschaum gefüllt ist.

7. Batteriesteuereinheit (100) nach einem der vorhergehenden Ansprüche, wobei die entsprechenden Kontaktflächen der Eingangsstromschiene (104) und der Ausgangsstromschiene (116) einstückig mit den Oberflächen der Eingangsstromschiene (104) und der Ausgangsstromschiene (118) ausgebildet sind, die der bestückten Schaltung (130) zugewandt sind.

8. Batteriesteuereinheit (100) nach einem der vorhergehenden Ansprüche, wobei ein erster der Mehrzahl von Detektionskontakten (166) an einer entsprechenden Kontaktfläche der Eingangsstromschiene (104) anliegt und ein zweiter der Mehrzahl von Detektionskontakten (168) an einer entsprechenden Kontaktfläche anliegt, die an der Ausgangsstromschiene (116) vorgesehen ist, und
wobei die Detektionsschaltung (186) eine erste Detektionsschaltung umfasst, die dazu eingerichtet ist, einen Spannungsabfall zwischen dem ersten der Mehrzahl von Detektionskontakten (166) und dem zweiten der Mehrzahl von Detektionskontakten (168) zu erfassen, und
wobei die Verarbeitungsschaltung (184) dazu eingerichtet ist, einen Wert der über der Schaltvorrichtung (102) abfallenden Spannung als einen Betriebsparameter der Schaltvorrichtung zu bestimmen.

9. Batteriesteuereinheit (100) nach einem der vorhergehenden Ansprüche, wobei die Stromschienenanordnung mindestens ein Widerstandselement (192) mit einem vorgegebenen Widerstand umfasst,
wobei ein dritter der Mehrzahl von Detektionskontakten (170) und ein vierter der Mehrzahl von Detektionskontakten (172) an entsprechenden Kontaktflächen der Stromschienenanordnung anliegen, die zum Erfassen eines Widerstandsspannungsabfalls über dem Widerstandselement (192) angeordnet sind; und
wobei die Detektionsschaltung (186) eine zweite Detektionsschaltung umfasst, die dazu eingerichtet ist, den Widerstandsspannungsabfall über dem Widerstandselement (192) mit dem dritten der Mehrzahl von Detektionskontakten (170) und dem vierten der Mehrzahl von Detektionskontakten (172) zu erfassen, und
wobei die Verarbeitungsschaltung (184) dazu eingerichtet ist, einen Stromwert eines durch die Schaltvorrichtung (102) fließenden Stroms als den mindestens einen Betriebsparameter auf der Grundlage der erfassten Widerstandsspannung zu bestimmen; und
optional, wobei das Widerstandselement (192) einstückig mit einer der Eingangsstromschiene (104) und der Ausgangsstromschiene (118) ausgebildet ist.

10. Batteriesteuereinheit (100) nach einem der vorhergehenden Ansprüche, wobei die bestückte Schaltung (130) einen Temperatursensor umfasst, der thermisch mit mindestens einer der Eingangsstromschiene (104) und der Ausgangsstromschiene (116) durch mindestens einen der Mehrzahl von Detektionskontakten (166, 168, 170, 172, 174, 176, 178, 180, 182) gekoppelt ist,
wobei die Verarbeitungsschaltung (184) dazu eingerichtet ist, eine Temperatur des Temperatursensors als einen Betriebsparameter der Schaltvorrichtung (102) zu bestimmen.

11. Batteriesteuereinheit (100) nach einem der vorhergehenden Ansprüche,
wobei die Stromschienenanordnung ferner einen Masseanschluss (188) umfasst, der elektrisch von der Eingangsstromschiene (104) und von der Ausgangsstromschiene (116) isoliert ist, zum elektrischen Verbinden eines Massepotentials,
wobei ein fünfter der Mehrzahl von Detektionskontakten (180) an einer entsprechenden Kontaktfläche des Masseanschlusses (188) anliegt,
wobei die Detektionsschaltung (186) eine dritte Detektionsschaltung umfasst, die dazu eingerichtet ist, eine dritte Detektionsspannung zu erfassen, die einen Leckpfadwiderstand zwischen dem Masseanschluss (188) und einer der Eingangsstromschiene (104) und der Ausgangsstromschiene (116) angibt, und
wobei die Verarbeitungsschaltung (184) dazu eingerichtet ist, den Leckpfadwiderstand als einen Betriebsparameter der Schaltvorrichtung (102) zu bestimmen.

12. Batteriesteuereinheit (100) nach einem der vorhergehenden Ansprüche, wobei die bestückte Schaltung (130) eine erste Kommunikationsschnittstelle (144) zum Kommunizieren mit mindestens einer Zellüberwachungsvorrichtung umfasst, die Batterieparameter einer Hochspannungsbatterie überwacht; und
wobei die Verarbeitungsschaltung (184) dazu eingerichtet ist, den Betrieb der Schaltvorrichtung (102) in Übereinstimmung mit mindestens einem Batterieparameter zu steuern, der von der ersten Kommunikationsschnittstelle (144) von der Zellüberwachungsvorrichtung empfangen wird; und/oder
wobei die bestückte Schaltung (130) eine zweite Kommunikationsschnittstelle (148) zum Durchführen einer Kommunikation mit einer externen Steuerung umfasst, die dazu eingerichtet ist, eine Hochspannungsbatterie zu steuern; und
wobei die Verarbeitungsschaltung (184) dazu eingerichtet ist, den Betrieb der Schaltvorrichtung (102) in Übereinstimmung mit einem Steuerbefehl zu steuern, der von der zweiten Kommunikationsschnittstelle (148) von der externen Steuerung empfangen wird.

13. Batteriesteuereinheit (100) nach einem der vorhergehenden Ansprüche, wobei die Schaltvorrichtung (102) dazu eingerichtet ist, zwischen einem geöffneten Zustand und einem geschlossenen Zustand zu schalten, wobei in dem geöffneten Zustand ein Stromfluss durch die Schaltvorrichtung (102) unterbrochen ist und in dem geschlossenen Zustand ein Stromfluss durch die Schaltvorrichtung (102) zugelassen ist, und
wobei die Verarbeitungsschaltung (184) dazu eingerichtet ist, die Schaltvorrichtung in Übereinstimmung mit dem mindestens einen von der Detektionsschaltung (186) erfassten Betriebsparameter zu schalten; und/oder
wobei die Batteriesteuereinheit (100) ferner mindestens eine Überstromschutzvorrichtung umfasst, die dazu eingerichtet ist, einen durch die Schaltvorrichtung (102) fließenden Überstrom zu verhindern; und
wobei die Verarbeitungsschaltung (184) dazu eingerichtet ist, den Betrieb der mindestens einen Überstromschutzvorrichtung in Übereinstimmung mit dem mindestens einen von der Detektionsschaltung (186) erfassten Betriebsparameter zu steuern.

14. Stromversorgungssystem, das mindestens eine Batterie und die Batteriesteuereinheit (100) nach einem der Ansprüche 1 bis 13 umfasst, wobei die mindestens eine Batterie leitend mit der Schaltvorrichtung (102) gekoppelt ist.

15. Verfahren zum Zusammenbauen einer Batteriesteuereinheit (100), wobei das Verfahren umfasst:
Montieren einer bestückten Schaltung (130) auf einer Leiterplatte (128), wobei die bestückte Schaltung (130) umfasst:
• eine Detektionsschaltung (186), die dazu eingerichtet ist, mindestens einen Betriebsparameter einer Schaltvorrichtung (102) zu erfassen; und
• eine Verarbeitungsschaltung (184), die dazu eingerichtet ist, den Betrieb der Schaltvorrichtung (102) in Übereinstimmung mit dem mindestens einen von der Detektionsschaltung (186) erfassten Betriebsparameter zu steuern; und
• eine Mehrzahl von Detektionskontakten (166, 168, 170, 172, 174, 176, 178, 180, 182) zum Erfassen des mindestens einen Betriebsparameters der Schaltvorrichtung (102);
**gekennzeichnet durch**
leitendes Koppeln der bestückten Schaltung (130) mit einer Stromschienenanordnung, die eine Eingangsstromschiene (104) und eine Ausgangsstromschiene (116) umfasst, wobei die Mehrzahl von Detektionskontakten (166, 168, 170, 172, 174, 176, 178, 180, 182) gegen entsprechende Kontaktflächen gedrückt wird, die an der Eingangsstromschiene (104) und an der Ausgangsstromschiene (116) vorgesehen sind, um an den entsprechenden Kontaktflächen anzuliegen, und
leitendes Koppeln der Eingangsstromschiene (104) mit einem ersten Anschluss der Schaltvorrichtung (102) und der Ausgangsstromschiene (116) mit einem zweiten Anschluss der Schaltvorrichtung (102).

## Revendications

1. Unité de commande de batterie (100) comprenant :
un dispositif de commutation (102) ; et
un circuit assemblé (130), qui est monté sur une carte de circuit imprimé (128), dans laquelle le circuit assemblé (130) comprend :
• un circuit de détection (186), qui est configuré pour détecter au moins un paramètre de fonctionnement du dispositif de commutation (102) ; et
• un circuit de traitement (184), qui est configuré pour commander le fonctionnement du dispositif de commutation (102) conformément à l'au moins un paramètre de fonctionnement détecté par le circuit de détection (186) ; et
• une pluralité de contacts de détection (166, 168, 170, 172, 174, 176, 178, 180, 182) pour détecter l'au moins un paramètre de fonctionnement du dispositif de commutation (102) ; et
un agencement de barres omnibus, qui comprend une barre omnibus d'entrée (104), qui est couplée de manière conductrice à une borne d'entrée du dispositif de commutation (102), et une barre omnibus de sortie (116), qui est couplée de manière conductrice à une borne de sortie du dispositif de commutation (102),
**caractérisée en ce que** la carte de circuit imprimé (128) est disposée par rapport à l'agencement de barres omnibus de telle sorte que la pluralité de contacts de détection (166, 168, 170, 172, 174, 176, 178, 180, 182) est pressée contre des surfaces de contact correspondantes prévues sur la barre omnibus d'entrée (104) et sur la barre omnibus de sortie (116).

2. Unité de commande de batterie (100) selon la revendication 1, dans laquelle la barre omnibus d'entrée (104) et la barre omnibus de sortie (116) comprennent chacune une partie de corps principale (132), qui s'étend sensiblement parallèlement à la carte de circuit imprimé (128), et une région d'extrémité (108), qui est couplée de manière conductrice à la borne d'entrée du dispositif de commutation (102), dans laquelle la région d'extrémité (108) de la barre omnibus d'entrée (104) est pliée par rapport à la partie de corps principale (132) de la barre omnibus d'entrée (104), et
dans laquelle une région d'extrémité (120) de la barre omnibus de sortie (116), qui est couplée de manière conductrice à la borne de sortie du dispositif de commutation (102), est pliée par rapport à la partie de corps principale (132) de la barre omnibus de sortie (116).

3. Unité de commande de batterie (100) selon la revendication 2, dans laquelle la carte de circuit imprimé (128) est disposée entre le dispositif de commutation (102) et un plan qui est défini par les parties de corps principales (132) de la barre omnibus d'entrée (104) et de la barre omnibus de sortie (116).

4. Unité de commande de batterie (100) selon l'une quelconque des revendications précédentes, comprenant en outre un élément de boîtier de barres omnibus (124), qui loge la barre omnibus d'entrée (104) et la barre omnibus de sortie,
dans laquelle l'élément de boîtier de barres omnibus (124) isole la barre omnibus d'entrée (104) et la barre omnibus de sortie (116) du circuit assemblé (130) et expose les surfaces de contact de la barre omnibus d'entrée (104) et de la barre omnibus de sortie (116) à la pluralité de contacts de détection (166, 168, 170, 172, 174, 176, 178, 180, 182).

5. Unité de commande de batterie (100) selon l'une quelconque des revendications précédentes, dans laquelle une surface inférieure de l'élément de boîtier de barres omnibus (124), qui est orientée à l'opposé du circuit assemblé (130), est recouverte d'un couvercle inférieur isolant (134), qui est formé d'un matériau isolant, et dans laquelle une surface externe du couvercle inférieur isolant (134) forme une surface de refroidissement (136) pour refroidir la barre omnibus d'entrée (104) et la barre omnibus de sortie (118).

6. Unité de commande de batterie (100) selon l'une quelconque des revendications précédentes, dans laquelle la pluralité de contacts de détection (166, 168, 170, 172, 174, 176, 178, 180, 182) est formée d'éléments de contact compressibles, en particulier dans laquelle la pluralité de contacts de détection est formée chacun d'une bande métallique en forme de ruban, qui est remplie à moitié d'une mousse isolante.

7. Unité de commande de batterie (100) selon l'une quelconque des revendications précédentes, dans laquelle les surfaces de contact correspondantes de la barre omnibus d'entrée (104) et de la barre omnibus de sortie (116) sont formées d'un seul tenant avec les surfaces de la barre omnibus d'entrée (104) et de la barre omnibus de sortie (118) qui font face au circuit assemblé (130).

8. Unité de commande de batterie (100) selon l'une quelconque des revendications précédentes, dans laquelle un premier de la pluralité de contacts de détection (166) vient en butée contre une surface de contact correspondante de la barre omnibus d'entrée (104) et un deuxième de la pluralité de contacts de détection (168) vient en butée contre une surface de contact correspondante prévue sur la barre omnibus de sortie (116), et
dans laquelle le circuit de détection (186) comprend un premier circuit de détection, qui est configuré pour détecter une chute de tension entre le premier de la pluralité de contacts de détection (166) et le deuxième de la pluralité de contacts de détection (168), et
dans laquelle le circuit de traitement (184) est configuré pour déterminer une valeur de la tension chutant aux bornes du dispositif de commutation (102) en tant que paramètre de fonctionnement du dispositif de commutation.

9. Unité de commande de batterie (100) selon l'une quelconque des revendications précédentes, dans laquelle l'agencement de barres omnibus comprend au moins un élément résistif (192) ayant une résistance prédéfinie,
dans laquelle un troisième de la pluralité de contacts de détection (170) et un quatrième de la pluralité de contacts de détection (172) viennent en butée contre des surfaces de contact correspondantes de l'agencement de barres omnibus, qui sont disposées pour détecter une chute de tension résistive aux bornes de l'élément résistif (192) ; et
dans laquelle le circuit de détection (186) comprend un deuxième circuit de détection, qui est configuré pour détecter la chute de tension résistive aux bornes de l'élément résistif (192) avec le troisième de la pluralité de contacts de détection (170) et le quatrième de la pluralité de contacts de détection (172), et
dans laquelle le circuit de traitement (184) est configuré pour déterminer une valeur de courant d'un courant circulant à travers le dispositif de commutation (102) en tant qu'au moins un paramètre de fonctionnement sur la base de la tension résistive détectée ; et
facultativement, dans laquelle l'élément résistif (192) est formé d'un seul tenant avec l'une de la barre omnibus d'entrée (104) et de la barre omnibus de sortie (118).

10. Unité de commande de batterie (100) selon l'une quelconque des revendications précédentes, dans laquelle le circuit assemblé (130) comprend un capteur de température, qui est couplé thermiquement à au moins l'une de la barre omnibus d'entrée (104) et de la barre omnibus de sortie (116) par au moins un de la pluralité de contacts de détection (166, 168, 170, 172, 174, 176, 178, 180, 182),
dans laquelle le circuit de traitement (184) est configuré pour déterminer une température du capteur de température en tant que paramètre de fonctionnement du dispositif de commutation (102).

11. Unité de commande de batterie (100) selon l'une quelconque des revendications précédentes,
dans laquelle l'agencement de barres omnibus comprend en outre une borne de masse (188), qui est isolée électriquement de la barre omnibus d'entrée (104) et de la barre omnibus de sortie (116), pour connecter électriquement un potentiel de masse,
dans laquelle un cinquième de la pluralité de contacts de détection (180) vient en butée contre une surface de contact correspondante de la borne de masse (188),
dans laquelle le circuit de détection (186) comprend un troisième circuit de détection, qui est configuré pour détecter une troisième tension de détection, qui indique une résistance du chemin de fuite entre la borne de masse (188) et l'une de la barre omnibus d'entrée (104) et de la barre omnibus de sortie (116), et
dans laquelle le circuit de traitement (184) est configuré pour déterminer la résistance du chemin de fuite en tant que paramètre de fonctionnement du dispositif de commutation (102).

12. Unité de commande de batterie (100) selon l'une quelconque des revendications précédentes, dans laquelle le circuit assemblé (130) comprend une première interface de communication (144) pour effectuer une communication avec au moins un dispositif de surveillance de cellule, qui surveille des paramètres de batterie d'une batterie haute tension ; et
dans laquelle le circuit de traitement (184) est configuré pour commander le fonctionnement du dispositif de commutation (102) conformément à au moins un paramètre de batterie, qui est reçu par la première interface de communication (144) en provenance du dispositif de surveillance de cellule ; et/ou
dans laquelle le circuit assemblé (130) comprend une deuxième interface de communication (148) pour effectuer une communication avec un contrôleur externe, qui est configuré pour commander une batterie haute tension ; et
dans laquelle le circuit de traitement (184) est configuré pour commander le fonctionnement du dispositif de commutation (102) conformément à une instruction de commande, qui est reçue par la deuxième interface de communication (148) en provenance du contrôleur externe.

13. Unité de commande de batterie (100) selon l'une quelconque des revendications précédentes, dans laquelle le dispositif de commutation (102) est configuré pour commuter entre un état ouvert et un état fermé, dans laquelle, dans l'état ouvert, une circulation de courant à travers le dispositif de commutation (102) est interrompue, et dans l'état fermé, une circulation de courant à travers le dispositif de commutation (102) est autorisée, et
dans laquelle le circuit de traitement (184) est configuré pour commuter le dispositif de commutation conformément à l'au moins un paramètre de fonctionnement détecté par le circuit de détection (186) ; et/ou
dans laquelle l'unité de commande de batterie (100) comprend en outre au moins un dispositif de protection contre les surintensités, qui est configuré pour empêcher une surintensité de circuler à travers le dispositif de commutation (102) ; et
dans laquelle le circuit de traitement (184) est configuré pour commander le fonctionnement de l'au moins un dispositif de protection contre les surintensités conformément à l'au moins un paramètre de fonctionnement détecté par le circuit de détection (186).

14. Système d'alimentation électrique, comprenant au moins une batterie et l'unité de commande de batterie (100) selon l'une quelconque des revendications 1 à 13, dans lequel l'au moins une batterie est couplée de manière conductrice au dispositif de commutation (102).

15. Procédé d'assemblage d'une unité de commande de batterie (100), le procédé comprenant :
le montage d'un circuit assemblé (130) sur une carte de circuit imprimé (128), dans lequel le circuit assemblé (130) comprend :
• un circuit de détection (186), qui est configuré pour détecter au moins un paramètre de fonctionnement d'un dispositif de commutation (102) ; et
• un circuit de traitement (184), qui est configuré pour commander le fonctionnement du dispositif de commutation (102) conformément à l'au moins un paramètre de fonctionnement détecté par le circuit de détection (186) ; et
• une pluralité de contacts de détection (166, 168, 170, 172, 174, 176, 178, 180, 182) pour détecter l'au moins un paramètre de fonctionnement du dispositif de commutation (102) ;
**caractérisé par**
le couplage conducteur du circuit assemblé (130) à un agencement de barres omnibus, qui comprend une barre omnibus d'entrée (104) et une barre omnibus de sortie (116), dans lequel la pluralité de contacts de détection (166, 168, 170, 172, 174, 176, 178, 180, 182) est pressée contre des surfaces de contact correspondantes prévues sur la barre omnibus d'entrée (104) et sur la barre omnibus de sortie (116), de manière à venir en butée contre les surfaces de contact correspondantes, et
le couplage conducteur de la barre omnibus d'entrée (104) à une première borne du dispositif de commutation (102) et de la barre omnibus de sortie (116) à une deuxième borne du dispositif de commutation (102).
